# FASCICULE DE BREVET EUROPEEN

(11) **EP 3 071 932 B1**
(45) Date de publication et mention de la délivrance du brevet: **10.10.2018**
(21) Numéro de dépôt: 14790041.9
(22) Date de dépôt: 21.10.2014
(51) Int. Cl.: G01C 19/574, B81B 3/00, B81C 1/00, G01C 19/5733, G01C 19/5769

(54) **CAPTEUR INERTIEL A MASSES SISMIQUES IMBRIQUÉES ET PROCÉDÉ DE FABRICATION D'UN TEL CAPTEUR**
TRÄGHEITSSENSOR MIT VERSCHACHTELTEN SEISMISCHEN MASSEN UND VERFAHREN ZUR HERSTELLUNG EINES DERARTIGEN SENSORS
INERTIAL SENSOR WITH NESTED SEISMIC MASSES AND METHOD FOR MANUFACTURING SUCH A SENSOR

(30) Priorité: 20.11.2013 FR 1361434
(43) Date de publication de la demande: 28.09.2016
(73) Titulaire: Safran Electronics & Defense, 92100 Boulogne-Billancourt (FR)
(72) Inventeur: JEANROY, Alain, F-92100 Boulogne-Billancourt (FR); ONFROY, Philippe, F-92100 Boulogne Billancourt (FR)
(74) Mandataire: Lavialle, Bruno François Stéphane
(86) Numéro de dépôt international: PCT/EP2014/072581
(87) Numéro de publication internationale: WO 2015/074818

(56) Documents cités:
- FR-A1- 2 983 574
- US-A1- 2011 232 384
- US-A1- 2012 125 098

## Description

La présente invention concerne un capteur inertiel à masses vibrantes, tel qu'un capteur angulaire de type gyroscope ou gyromètre.

Un tel capteur inertiel comprend un bâti et des corps sismiques (couramment appelés masses sismiques ou masses d'épreuve) qui sont généralement disposés côte-à-côte et reliés au bâti par des charnières élastiques pour être mobiles dans un plan de suspension défini par deux directions orthogonales de déplacement des corps sismiques. L'élasticité des charnières associée à la masse des corps sismiques définit les fréquences des modes propres des corps sismiques. Le capteur comprend également des actionneurs agencés pour mettre en vibration les corps sismiques et des détecteurs agencés pour détecter des mouvements relatifs des corps sismiques.

Le résonateur constitué par les corps sismiques et les charnières élastiques possède deux modes utiles de vibration, définissant deux directions de déplacement des corps sismiques. La détection des vibrations des corps sismiques selon ces directions permet d'effectuer une mesure angulaire.

Les performances de ces capteurs sont d'autant plus élevées que l'anisotropie d'amortissement du résonateur est stable. Cette stabilité dépend de la stabilité des caractéristiques d'amortissement du résonateur et de la stabilité des échanges d'énergie entre le résonateur et le monde extérieur. L'anisotropie d'amortissement doit être la plus stable possible pour ne pas engendrer d'imprécision sur les mesures réalisées au moyen du capteur angulaire.

Les échanges d'énergie entre le résonateur et le monde extérieur dépendent de :
- l'amortissement moyen (en relation avec la constante de temps du capteur) qui doit être le plus faible possible, pour limiter l'apport d'énergie nécessaire au maintien d'une amplitude constante de la vibration et limiter l'imprécision de cet apport d'énergie,
- l'équilibrage des modes utiles de vibration des corps sismiques qui doit limiter les forces et couples de réactions sur le bâti pour les modes utiles et ainsi limiter le transfert d'énergie vers l'extérieur, et réciproquement limiter la sensibilité à l'environnement vibratoire extérieur des modes utiles de vibration,
- le plan de fréquences des corps sismiques qui doit présenter un écartement important entre les fréquences des modes utiles et les fréquences de modes de vibration non exploités pour la mesure pour limiter les transferts d'énergie entre ces modes.

Lorsque le résonateur comprend deux corps sismiques côte-à-côte, le résonateur est équilibré en translation sur un des deux modes utiles, pour lequel les corps sismiques oscillent sur un même axe en opposition de phase mais des couples sont engendrés par l'autre mode utile pour lequel les corps sismiques oscillent en opposition de phase sur deux axes écartés et parallèles. Ces couples transmettent des efforts donc de l'énergie au monde extérieur et réciproquement les déplacements des corps sismiques sont contrariés par les couples créés en réponse au déplacement angulaire du porteur du capteur.

Lorsque le résonateur comprend quatre corps sismiques disposés en carré, le résonateur est totalement équilibré pour les deux modes propres utiles mais son plan de fréquence n'est pas optimal, les modes utiles de vibration étant proches de modes non exploités qui peuvent créer des échanges d'énergie avec les deux modes utiles.

Différentes solutions ont été proposées pour améliorer les performances des capteurs comme, par exemple, dans le document FR-A-2983574 et dans le document US-A-2012/0125098. Ce dernier document décrit un capteur ayant deux corps sismiques de même forme, de même masse, et imbriqués l'un dans l'autre, ces corps sismiques n'ayant pas leurs centres de gravité confondus l'un avec l'autre.

Un but de l'invention est de fournir un moyen pour améliorer les performances des capteurs.

A cet effet, on prévoit, selon l'invention, un capteur inertiel comprenant un bâti auquel au moins deux corps sismiques sont reliés par des moyens élastiques pour être mobiles dans un plan de suspension, et des transducteurs pour maintenir en vibration les corps sismiques et pour déterminer un mouvement relatif des corps sismiques l'un par rapport à l'autre. Les corps sismiques ont une même forme et une même masse et les corps sismiques comportent des parties d'emboîtement de telle manière que les corps sismiques soient mutuellement imbriqués l'un dans l'autre tout en étant mobiles dans le plan de suspension relativement à l'autre des corps sismiques, les corps sismiques ayant des centres de gravité confondus l'un avec l'autre.

Comme les corps sismiques ont des formes et des masses identiques, et que leurs centres de gravité sont confondus, les corps sismiques ont la même inertie et subissent la même influence des effets extérieurs. Ceci concourt à l'équilibrage du résonateur pour les deux modes propres utiles et à la stabilité de l'anisotropie d'amortissement.

L'invention a également pour objet un procédé de fabrication d'un tel capteur, comprenant l'étape de graver le capteur dans une galette comportant au moins une couche électriquement isolante entre deux couches de matériau semi-conducteur de telle manière que la couche électriquement isolante s'étende entre les ailes et l'âme de chaque corps sismique.

D'autres caractéristiques et avantages de l'invention ressortiront à la lecture de la description qui suit de modes de réalisation particuliers non limitatifs de l'invention.

Il sera fait référence aux dessins annexés, parmi lesquels :

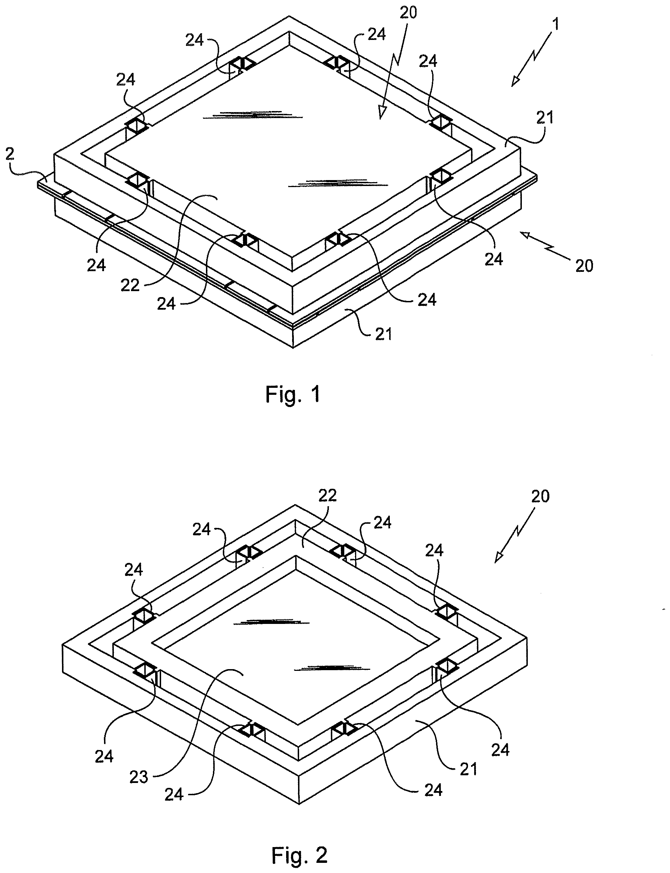

- la figure 1 est une vue en perspective de ce capteur,
- la figure 2 est une vue en perspective d'une partie du boîtier de ce capteur,

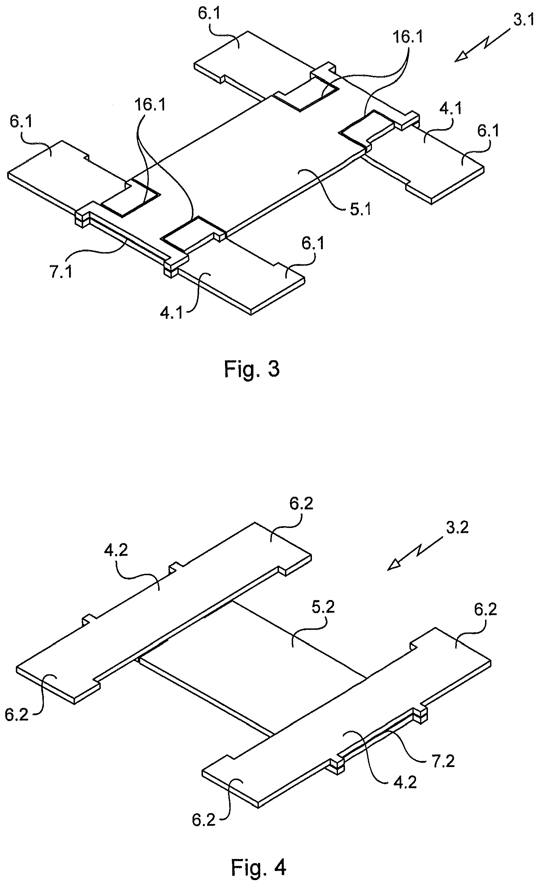

- la figure 3 est une vue en perspective d'un des corps sismiques d'un capteur selon un premier mode de réalisation de l'invention,
- la figure 4 est une vue analogue à la figure 1 de l'autre des corps sismiques de ce capteur,

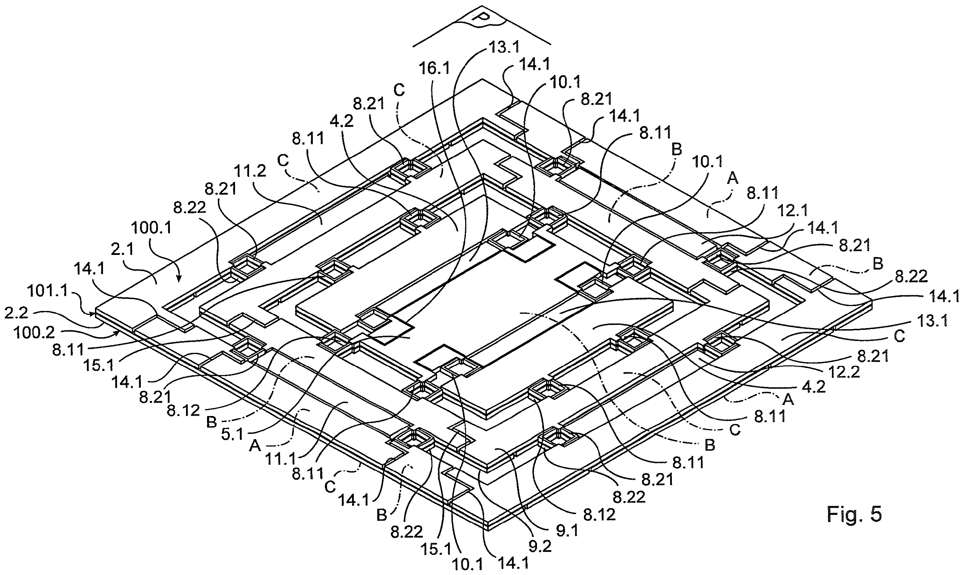

- la figure 5 est une vue en perspective de ce capteur, sans le boîtier.

En référence aux figures, le capteur selon le premier mode de réalisation de l'invention, généralement désigné en 1, est ici un capteur de type MEMS (de l'anglais « Micro Electro-Mechanical System ») réalisé à partir d'une galette comportant deux couches semi-conductrices 100.1, 100.2 et une couche isolante électriquement 101.1. La couche isolante 101.1 s'étend entre la première couche semi-conductrice 100.1 et la deuxième couche semi-conductrice 100.2. Les couches semi-conductrices 100.1, 100.2 sont en matériau semi-conducteur, ici en silicium, et la couche isolante 101.1 est en un oxyde de silicium tel que le SiO₂.

Dans chaque couche semi-conductrice 100.1, 100.2 sont formés :
- un bâti 2.1, 2.2 formant un cadre externe ;
- un cadre intermédiaire 9.1, 9.2 ;
- des portions de corps sismiques généralement désignés en 3.1, 3.2 ;
- des premiers éléments élastiques 8.11, 8.12 reliant le corps sismique 3.1, 3.2 au cadre intermédiaire 9.1, 9.2 ;
- des deuxièmes éléments élastiques 8.21, 8.22 reliant le cadre intermédiaire 9.1, 9.2 au bâti 2.1, 2.2 ;
- des troisièmes éléments élastiques 10.1, 10.2 (seuls les éléments élastiques 10.1 sont visibles sur les figures) reliant les portions de corps sismiques 3.1, 3.2 entre elles ;
- des premiers transducteurs 11.1, 11.2 s'étendant entre un premier côté du bâti 2.1, 2.2 et un premier côté du cadre intermédiaire 9.1, 9.2 en regard ;
- des deuxièmes transducteurs 12.1, 12.2 s'étendant entre un deuxième côté du bâti 2.1, 2.2 et un deuxième côté du cadre intermédiaire 9.1, 9.2 en regard, le deuxième côté portant les transducteurs 12.1 étant à l'opposé du premier côté portant les transducteurs 11.1 et le deuxième côté portant les transducteurs 12.2 étant à l'opposé du premier côté portant les transducteurs 11.2 ;
- des troisièmes transducteurs 13.1, 13.2 (seuls les transducteurs 13.1 sont visibles sur les figures) s'étendant entre les portions de corps sismiques 3.1, 3.2.

Chaque corps sismique 3.1, 3.2 comprend respectivement deux ailes 4.1, 4.2 parallélépipédiques qui s'étendent parallèlement l'une à l'autre en étant écartées l'une de l'autre et sont reliées l'une à l'autre par une âme centrale 5.1, 5.2 parallélépipédique s'étendant en retrait des ailes 4.1, 4.2. L'âme centrale 5.1, 5.2 a une largeur inférieure à l'écartement des ailes 4.1, 4.2. Les ailes 4.1 du corps sismique 3.1 sont formées dans la couche semi-conductrice 100.2 et l'âme centrale 5.1 du corps sismique 3.1 est formée dans la couche semi-conductrice 100.1. Les ailes 4.2 du corps sismique 3.2 sont formées dans la couche semi-conductrice 100.1 et l'âme centrale 5.2 du corps sismique 3.2 est formée dans la couche semi-conductrice 100.2. Une portion 7.1, 7.2 de la couche isolante entre 100.1, 100.2 s'étend entre les ailes 4.1, 4.2 et l'âme 5.1, 5.2 pour isoler électriquement les ailes 4.1, 4.2 de l'âme 5.1, 5.2.

Les corps sismiques 3.1, 3.2 sont montés mobiles selon un plan prédéterminé P. Les corps sismiques 3.1, 3.2 ont une même forme et une même masse. Les corps sismiques 3.1, 3.2 sont positionnés pour avoir des centres de gravité confondus l'un avec l'autre. Chaque aile 4.1, 4.2 a une masse inférieure de moitié à la masse de l'âme 5.1, 5.2.

Les agencements des couches semi-conductrices 100.1, 100.2 sont orientés à 90° l'un par rapport à l'autre autour d'un axe normal au plan prédéterminé P et à 180° autour d'un axe du plan prédéterminé P de telle manière que l'âme 5.1, 5.2 de chacun des corps sismiques 3.1, 3.2 s'étende en regard de l'âme 5.1, 5.2 et entre les ailes 4.1, 4.2 de l'autre des corps sismiques 3.1, 3.2. Ainsi, les ailes 4.1, 4.2 de chacun des corps sismiques 3.1, 3.2 ont des portions d'extrémité 6.1, 6.2 s'étendant dans le même plan que l'âme 5.2, 5.1 de l'autre des corps sismiques 3.2, 3.1 et en regard de portions d'extrémité 6.2, 6.1 des ailes 4.2, 4.1 de l'autre des corps sismiques 3.2, 3.1.

Les corps sismiques 3.1, 3.2 comportent ainsi des parties d'emboîtement (les ailes 4.1, 4.2) de telle manière que les corps sismiques 3.1, 3.2 soient mutuellement imbriqués l'un dans l'autre tout en étant mobiles chacun selon le plan prédéterminé P relativement à l'autre des corps sismiques 3.2, 3.1.

Les premiers éléments élastiques 8.11, 8.12 et les deuxièmes éléments élastiques 8.21, 8.22 forment un premier étage de suspension et un deuxième étage de suspension des corps sismiques 3.1, 3.2.

Les éléments élastiques sont ici formés de lamelles élastiquement déformables parallèlement au plan de suspension P, mais qui présentent une raideur élevée selon l'axe normal au plan de suspension pour supprimer les degrés de liberté des corps sismiques 3.1, 3.2 hors du plan de suspension P. Les éléments élastiques 8.11, 8.12, 8.21, 8.22 sont agencés pour assurer un couplage relativement faible du cadre intermédiaire 9.1, 9.2 avec les corps sismiques 3.1, 3.2 et avec le bâti 2.1, 2.2. Les premiers éléments élastiques 8.11, 8.12 ont des raideurs isotropes dans le plan P. Les deuxièmes éléments élastiques 8.21, 8.22 ont des raideurs isotropes dans le plan P. Les raideurs des premiers éléments élastiques 8.11, 8.12 et des deuxièmes éléments élastiques 8.21, 8.22 sont telles que les fréquences du premier mode propre du cadre intermédiaire 9.1, 9.2 et du mode propre d'ensemble des corps sismiques 3.1; 3.2 soient sensiblement inférieures à la fréquence des modes utiles. Les éléments élastiques 10.1, 10.2 ont des raideurs isotropes dans le plan P et sont agencés pour assurer un couplage relativement fort des corps sismiques 3.1, 3,2 entre eux. Les éléments élastiques 10.1, 10.2 ont donc une raideur supérieure à la raideur des éléments élastiques 8.11, 8.12, 8.21, 8.22.

Deux éléments élastiques 10.2 s'étendent parallèlement à l'âme centrale 5.1 entre chacune des ailes 4.1 du corps sismique 3.1 et l'âme centrale 5.2 du corps sismique 3.2 et deux éléments élastiques 10.1 s'étendent parallèlement à l'âme centrale 5.2 entre chacune des ailes 4.2 du corps sismique 3.2 et l'âme centrale 5.1 du corps sismique 3.1.

Les transducteurs 13 sont reliés à une unité de commande, non représentée ici, pour déterminer le mouvement relatif des corps sismiques 3.1, 3.2 l'un par rapport à l'autre.

Les transducteurs 11.1, 11.2 sont pilotés par l'unité de commande de manière à former successivement sur un premier axe un détecteur du déplacement relatif du cadre intermédiaire 9.1, 9.2 par rapport au bâti 2.1, 2.2 et un actionneur d'amortissement du premier mode propre de vibration du cadre intermédiaire 9.1, 9.2 par rapport au bâti 2.1, 2.2.

Les transducteurs 12.1, 12.2 sont pilotés par l'unité de commande de manière à former successivement sur un deuxième axe un détecteur du déplacement relatif du cadre intermédiaire 9.1, 9.2 par rapport au bâti 2.1, 2.2 et un actionneur d'amortissement du premier mode propre de vibration du cadre intermédiaire 9.1, 9.2 par rapport au bâti 2.1, 2.2.

Les transducteurs 13.1, 13.2 sont pilotés par l'unité de commande de manière à former successivement un actionneur de mise en vibration des corps sismiques 3.1, 3.2 et un détecteur du déplacement relatif des corps sismiques 3.1, 3.2.

Deux des transducteurs 13.2 s'étendent entre chacune des ailes 4.1 du corps sismique 3.1 et l'âme centrale 5.2 du corps sismique 3.2 et deux des transducteurs 13.1 s'étendent entre chacune des ailes 4.2 du corps sismique 3.2 et l'âme centrale 5.1 du corps sismique 3.1. Les transducteurs 13.1 ont la forme de deux électrodes, par exemple en peigne, qui pour chaque transducteur sont solidaires pour l'une de l'aile 4.1, 4.2 et pour l'autre de l'âme centrale 5.2, 5.1. Les électrodes sont d'une seule pièce avec les ailes 4.1, 4.2 et les âmes centrales 5.1, 5.2. On notera que les portions 7.1, 7.2 de couche isolante 101.1 permettent d'avoir des ailes 4.1, 4.2 et des âmes centrales 5.1, 5.2 à des potentiels différents.

La couche semi-conductrice 100.1, 100.2 comporte des fentes 14.1, 14.2 (seules les fentes 14.1 sont visibles) au niveau du premier côté et du deuxième côté du bâti 2.1, 2.2 pour délimiter une zone A en regard de chaque transducteur 11.1, 11.2 ; une zone B de part et d'autre de la zone A et en regard des deuxièmes éléments 8.21, 8.22 et une zone C entre les deux zones B.

La couche semi-conductrice 100.1, 100.2 comporte des fentes 15.1, 15.2 2 (seules les fentes 15.1 sont visibles) au niveau du premier côté et du deuxième côté du cadre intermédiaire 9.1, 9.2 pour délimiter une zone B en regard de chaque transducteur 11.1, 11.2, des deuxièmes éléments élastiques 8.21, 8.22 et des premiers éléments élastiques 8.11, 8.12, et une zone C entre les deux zones B.

La couche semi-conductrice 100.1, 100.2 comporte des fentes 16.1, 16.2 autour des troisièmes éléments élastiques 10.1, 10.2 pour délimiter une zone B en regard des premiers éléments élastiques 8.11, 8.12 et des transducteurs 13.1, 13.2.

Les transducteurs 11 et 12 ont chacun une électrode solidaire d'une zone B et une électrode solidaire d'une zone A. Les transducteurs 13 ont chacun une électrode solidaire d'une zone B et une électrode solidaire d'une zone C. Les électrodes sont ici en forme de peigne. Comme les fentes 14, 15, 16 s'étendent sur toute la hauteur de la couche semi-conductrice 100.1, 100.2, les zones A, B, C sont électriquement isolées et peuvent être portées à des potentiels différents pour transmettre des signaux de commande et/ou de détection. Les couches semi-conductrices 100.1, 100.2 étant séparées l'une de l'autre par la couche isolante 101.1, les zones A, B, C de la couche semi-conductrice 100.1 sont électriquement isolées des zones A, B, C de la couche semi-conductrice 100.2.

Les zones A, B, C permettent la conduction d'un signal de tension entre les transducteurs 11, 12, 13 et la périphérie du bâti 2.1, 2.2. L'unité de commande est électriquement connectée aux zones A, B, C au niveau de la périphérie du bâti 2.1, 2.2.

En fonctionnement les transducteurs 13 sont pilotés pour alternativement :
- mettre et maintenir en vibration l'ensemble corps sismiques 3.1, 3.2 et éléments élastiques 8.11, 8.12, 10.1, 10.2 à la fréquence de résonance de cet ensemble ;
- détecter les mouvements relatifs des corps sismiques 3.1, 3.2 entre eux.

Les transducteurs 11, 12 sont par exemple commandés pour créer une raideur électrostatique réglable du deuxième étage de suspension.

Le capteur peut comprendre un boîtier formé de deux parties généralement désignées en 20 entre lesquelles sont emprisonnés l'ensemble bâti 2.1, 2.2 / cadre intermédiaire 9.1, 9.2 / corps sismiques 3.1, 3.2 (et les transducteurs et moyens élastiques associés). Chaque partie 20 comprend un cadre 21 solidaire du bâti 1, et un capot 22 solidaire du cadre intermédiaire 9.1, 9.2 et relié au cadre 21 par des moyens élastiques 24. Le capot 22 de chaque partie 20 comporte une cavité 23 s'étendant en regard des corps sismiques 3.1, 3.2. Les capots 22 sont fixés sur le cadre support 9 de telle manière que la cavité 23 puisse être maintenue sous vide. Le capot 22 a une masse suffisante pour constituer une masse de recul pour les modes propres des corps sismiques 3.1, 3.2 permettant de séparer les fréquences des modes utiles et du mode de suspension créé par les deuxièmes éléments élastiques 8.21, 8.22 et d'atténuer au moins une partie des efforts parasites en provenance de l'extérieur.

Comme les corps sismiques ont des formes et des masses identiques, et que leurs centres de gravité sont confondus, les corps sismiques ont la même inertie et forment un résonateur équilibré qui ne transmet pas d'énergie à l'extérieur à la fréquence des modes utiles et ne subit pas d'influence des effets des vibrations extérieures. Ceci concourt à la stabilité de l'anisotropie d'amortissement, les performances du capteur étant d'autant meilleures que cette anisotropie est stable.

Le capteur selon l'invention est obtenu au moins en partie au moyen d'un procédé de fabrication comportant une phase de gravure de matériau cristallin.

Le procédé de fabrication comprend l'étape de graver le capteur dans la galette comportant les deux couches semi-conductrices 100.1, 100.2 et la couche isolante 101.1.

Les corps sismiques 3.1, 3.2 (ailes 4.1 et 4.2, âmes centrales 5.1 et 5.2, couches isolantes 7.1, 7.2), les bâtis 2.1, 2.2, les cadres intermédiaires 9, les éléments élastiques 8.11, 8.12, 8.21, 8.22, 10.1 et 10.2, les transducteurs 11.1, 11.2, 12.1, 12.2, 13.1, 13.2 et les fentes 14, 15, 16 sont directement issus de la gravure.

Chacune des parties de boîtier 20 est également obtenue par gravure d'un matériau cristallin.

D'une manière générale, on aura recours également aux technologies MEMS classiques regroupées sous le nom générique de « wafer bonding ». Dans le cas présent, on peut citer les techniques dites « direct bonding », « anodic bonding » et « metallic bonding ».

Bien entendu, l'invention n'est pas limitée aux modes de réalisation décrits mais englobe toute variante entrant dans le champ de l'invention telle que définie par les revendications.

En particulier, les corps sismiques peuvent avoir une forme différente de celle décrite.

Les transducteurs peuvent ne pas mesurer directement le mouvement relatif des corps sismiques 3.1 et 3.2 mais le déplacement de chacun de ces corps sismiques par rapport au support des corps sismiques, le mouvement relatif étant alors la différence de ces deux déplacements.

Le capteur peut ne pas avoir de boîtiers 20.

Le capteur peut n'avoir qu'un étage de suspension

Le capteur peut ne pas être de type MEMS pour des applications où l'encombrement n'est pas une contrainte.

La liaison électrique des transducteurs à l'unité de commande peut être réalisée sans recourir à des zones de conduction, par exemple à partir de pistes conductrices ou de fils conducteurs rapportés sur le matériau semi-cristallin.

En variante, le transducteur 11.1 peut être piloté en détecteur uniquement et le transducteur 12.1 peut être piloté en actionneur uniquement, ou inversement. Il en est de même pour les transducteurs 11.2, 12.2.

## Revendications

1. Capteur inertiel comprenant un bâti (2.1, 2.2) auquel au moins deux corps sismiques (3.1, 3.2) sont reliés par des moyens élastiques (8.11, 8.12, 8.21, 8.22) pour être mobiles dans un plan de suspension (P), et des transducteurs (11.1, 11.2, 12.1, 12.2, 13.1, 13.2) pour maintenir en vibration les corps sismiques et pour déterminer un mouvement relatif des corps sismiques l'un par rapport à l'autre, les corps sismiques ayant une même forme et une même masse et les corps sismiques comportant des parties d'emboîtement de telle manière que les corps sismiques soient mutuellement imbriqués l'un dans l'autre tout en étant mobiles dans le plan de suspension relativement à l'autre des corps sismiques, les corps sismiques ayant des centres de gravité confondus l'un avec l'autre.

2. Capteur selon la revendication 1, dans lequel chaque corps sismique (3.1, 3.2) comprend deux ailes (4.1, 4.2) parallélépipédiques qui s'étendent parallèlement l'une à l'autre et sont reliées l'une l'autre par une âme centrale (5.1, 5.2) parallélépipédique s'étendant en retrait des ailes, les corps sismiques étant orientés à 90° l'un par rapport à l'autre autour d'un axe normal au plan de suspension et à 180° autour d'un axe du plan de suspension de telle manière que l'âme de chacun des corps sismiques s'étende en regard de l'âme et entre les ailes de l'autre des corps sismiques et que les ailes de chacun des corps sismiques aient des portions d'extrémité s'étendant dans le même plan que l'âme et en regard de portions d'extrémité des ailes de l'autre des corps sismiques.

3. Capteur selon la revendication 2, dans lequel chaque aile (4.1, 4.2) a une masse inférieure de moitié à une masse de l'âme (5.1, 5.2).

4. Capteur selon la revendication 1, dans lequel les moyens élastiques comprennent des premiers moyens élastiques (8.11, 8.12) et des deuxièmes moyens élastiques (8.21, 8.22), et dans lequel les corps sismiques (3.1, 3.2) sont reliés par les premiers moyens élastiques (8.11, 8.12) à un cadre support (9.1, 9.2) relié au bâti (2.1, 2.2) par les deuxièmes moyens élastiques (8.21, 8.22) pour former un premier étage de suspension et un deuxième étage de suspension.

5. Capteur selon la revendication 1, dans lequel les transducteurs de détermination du mouvement relatif des corps sismiques comprennent des transducteurs (13.1, 13.2) s'étendant entre les corps sismiques (3.1, 3.2).

6. Capteur selon la revendication 2, dans lequel les corps sismiques (3.1, 3.2) sont en matériau semi-conducteur et comprennent une couche électriquement isolante (7.1, 7.2) s'étendant entre les ailes (4.1, 4.2) et l'âme (5.1, 5.2) pour isoler électriquement les ailes de l'âme.

7. Capteur selon la revendication 6, dans lequel le matériau semi-conducteur est le silicium et la couche isolante est en un oxyde de silicium.

8. Capteur selon la revendication 6, le capteur étant de type MEMS.

9. Procédé de fabrication d'un capteur selon la revendication 8, comprenant l'étape de graver le capteur dans une galette comportant au moins une couche électriquement isolante entre deux couches de matériau semi-conducteur de telle manière que la couche électriquement isolante s'étende entre les ailes et l'âme de chaque corps sismique.

## Patentansprüche

1. Trägheitssensor, umfassend einen Rahmen (2.1, 2.2), mit dem mindestens zwei seismische Körper (3.1, 3.2) über elastische Mittel (8.11, 8.12, 8.21, 8.22) verbunden sind, um in einer Aufhängungsebene (P) beweglich zu sein, und Wandler (11.1, 11.2, 12.1, 12.2, 13.1, 13.2), um die seismischen Körper in Schwingung zu halten und um eine Relativbewegung der seismischen Körper relativ zueinander zu bestimmen, wobei die seismischen Körper eine gleiche Form und eine gleiche Masse haben und die seismischen Körper Steckabschnitte haben, derart, dass die seismischen Körper ineinander verschachtelt sind, während sie in der Aufhängungsebene relativ zum anderen der seismischen Körper beweglich sind, wobei die seismischen Körper Schwerpunkte haben, die miteinander zusammenfallen.

2. Sensor nach Anspruch 1, bei dem jeder seismische Körper (3.1, 3.2) zwei parallelepipedische Flügel (4.1, 4.2) umfasst, die sich parallel zueinander erstrecken und miteinander über einen parallelepipedischen zentralen Steg (5.1, 5.2) verbunden sind, der sich zurückversetzt zu den Flügel erstreckt, wobei die seismischen Körper zueinander mit 90° um eine zur Aufhängungsebene senkrechte Achse und mit 180° um eine Achse der Aufhängungsebene ausgerichtet sind, derart, dass sich der Steg jedes der seismischen Körper gegenüber dem Steg und zwischen den Flügeln des anderen der seismischen Körper erstreckt, und dass die Flügel jedes der seismischen Körper Endabschnitte haben, die sich in der gleichen Ebene wie der Steg und gegenüber von Endabschnitten der Flügel des anderen der seismischen Körper erstrecken.

3. Sensor nach Anspruch 2, bei dem jeder Flügel (4.1, 4.2) eine Masse hat, die halb so groß wie eine Masse des Steges (5.1, 5.2) ist.

4. Sensor nach Anspruch 1, bei dem die elastischen Mittel erste elastische Mittel (8.11, 8.12) und zweite elastische Mittel (8.21, 8.22) umfassen und bei dem die seismischen Körper (3.1, 3.2) über die ersten elastischen Mittel (8.11, 8.12) mit einem Halterahmen (9.1, 9.2) verbunden sind, der mit dem Rahmen (2.1, 2.2) über die zweiten elastischen Mittel (8.21, 8.22) verbunden ist, um eine erste Aufhängungsstufe und eine zweite Aufhängungsstufe zu bilden.

5. Sensor nach Anspruch 1, bei dem die Wandler zum Bestimmen der Relativbewegung der seismischen Körper Wandler (13.1, 13.2) umfassen, die sich zwischen den seismischen Körpern (3.1, 3.2) erstrecken.

6. Sensor nach Anspruch 2, bei dem die seismischen Körper (3.1, 3.2) aus einem Halbleitermaterial sind und eine elektrisch isolierende Schicht (7.1, 7.2) umfassen, die sich zwischen den Flügeln (4.1, 4.2) und dem Steg (5.1, 5.2) erstreckt, um die Flügel von dem Steg elektrisch zu isolieren.

7. Sensor nach Anspruch 6, bei dem das Halbleitermaterial Silicium ist und die isolierende Schicht aus Siliciumoxid ist.

8. Sensor nach Anspruch 6, wobei der Sensor vom Typ MEMS ist.

9. Verfahren zum Herstellen eines Sensors nach Anspruch 8, umfassend den Schritt des Ätzens des Sensors in einen Wafer, der mindestens eine elektrisch isolierende Schicht zwischen zwei Schichten aus Halbleitermaterial umfasst, derart, dass sich die elektrisch isolierende Schicht zwischen den Flügeln und dem Steg jedes seismischen Körpers erstreckt.

## Claims

1. An inertial sensor comprising a frame (2.1, 2.2) to which at least two seismic bodies (3.1, 3.2) are connected by resilient means (8.11, 8.12, 8.21, 8.22) so as to be movable in a suspension plane (P), and transducers (11.1, 11.2, 12.1, 12.2, 13.1, 13.2) to keep the seismic bodies vibrating and to determine a relative movement of the seismic bodies relative to one another, the seismic bodies having a single shape and a single mass, the seismic bodies comprising interlocking parts such that the seismic bodies are nested inside one another while being movable in the suspension plane relative to the other of the seismic bodies, with the seismic bodies having centres of gravity that coincide with one another.

2. A sensor according to claim 1, wherein each seismic body (3.1, 3.2) comprises two parallelepiped wings (4.1, 4.2) which extend parallel with one another and are connected together by a parallelepiped central core (5.1, 5.2) which extends back from the wings, with the seismic bodies being oriented at 90° with respect to one another about an axis normal to the suspension plane and at 180° about an axis of the suspension plane, so that the core of each seismic body extends opposite the core and between the wings of the other of the seismic bodies and that the wings of each seismic body has end portions which extend in the same plane as the core and opposite end portions of the wings of the other of the seismic bodies.

3. A sensor according to claim 2, wherein each wing (4.1, 4.2) has a mass equal to half the mass of the core (5.1, 5.2).

4. A sensor according to claim 1, wherein the resilient means comprises first resilient means (8.11, 8.12) and second resilient means (8.21, 8.22), and in which the seismic bodies (3.1, 3.2) are connected by first resilient means (8.11, 8.12) to a support framework (9.1,9.2) connected to the frame (2.1, 2.2) by second resilient means (8.21, 8.22) to form a first suspension stage and a second suspension stage.

5. A sensor according to claim 1, wherein the transducers for determining the relative movement of the seismic bodies comprise transducers (13.1, 13.2) which extend between the seismic bodies (3.1, 3.2).

6. A sensor according to claim 2, wherein the seismic bodies (3.1, 3.2) are made of a semi-conductor material and comprise an electrically insulating layer (7.1, 7.2) extending between the wings (4.1, 4.2) and the core (5.1, 5.2) so as to electrically insulate the wings from the core.

7. A sensor according to claim 6, wherein the semi-conductor material is silicon and the insulating layer is made of silicon dioxide.

8. A sensor according to claim 6, wherein the sensor is of the MEMS type.

9. A method for manufacturing a sensor according to claim 8, comprising the step of etching the sensor into a wafer comprising at least one electrically insulating layer between two layers of semi-conductor material so that the electrically insulating layer extends between the wings and the core of each seismic body.
